Europäisches Patentamt

European Patent Office

Office européen des brevets

(11) Veröffentlichungsnummer: **0 489 341 A1**

## (12) EUROPÄISCHE PATENTANMELDUNG

(21) Anmeldenummer: **91120213.3**

(22) Anmeldetag: **26.11.91**

(51) Int. Cl.⁵: **H05K 7/20**

(30) Priorität: **05.12.90 DE 4038788**

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **BSG-Schalttechnik GmbH & Co. KG**
**Meisterstrasse 19**
**W-7460 Balingen 1(DE)**

(72) Erfinder: **Lohner, Martin**
**Blumenthalstrasse 16**
**W-7460 Balingen-Ostdorf(DE)**

(74) Vertreter: **Otte, Peter, Dipl.-Ing. et al**
**Tiroler Strasse 15**
**W-7250 Leonberg(DE)**

(54) **Gehäuse für elektrische Schaltungen.**

(57) Bei einem elektrischen Schaltungen aufnehmenden Gehäuse wird vorgeschlagen, eine Stelle oder eine Seite des Gehäuses offen zu lassen und mit einem separaten Kühlkörper aus gut wärmeleitendem Material abzudecken, wobei dann mindestens ein elektrisches, eine größere Verlustwärme aufweisendes Element mit der Innenfläche der Kühlkörper-Gehäusewandung in guter wärmeleitender Verbindung steht, so daß ein Kompaktgehäuse mit einem inneren Hohlraum gebildet ist, das gleichzeitig auch noch als Vergußrahmen für die Aufnahme von Vergußmasse dienen kann.

Fig.1

EP 0 489 341 A1

## Stand der Technik

Die Erfindung geht aus von einem Gehäuse für elektrische Schaltungen nach dem Oberbegriff des Anspruchs 1.

Gehäuse für elektrische Schaltungen sind in vielfältiger Form bekannt; zumeist handelt es sich bei diesen um einfache Print- oder Leitungsplatten, auf denen elektrische Schaltungselemente aufgebracht und verlötet sind - eine solche Leitungsplatte kann als einfachste Gehäuseform zur Lagerung von elektrischen Schaltungselementen und damit auch der von diesen Elementen gebildeten Schaltung angesehen werden. Es ist darüber hinaus auch üblich, eventuell nur Teilbereiche oder die gesamte Leitungsplatte mit einem Rahmen zu versehen, in welchen eine Vergußmasse eingefüllt wird; ein solcher Vergußrahmen bildet dann zusammen mit der ihn tragenden Leitungsplatte und der Vergußmasse eine gehäuseartige Umschließung für die Schaltung und schützt deren empfindliche Teilelemente gleichzeitig gegen Beschädigung oder Einwirkungen von außen.

Natürlich ist es auch möglich, Leitungsplatten in genormter Form als Einschübe in kastenförmige Gehäuse einzusetzen oder, häufiger für elektrische Teileelemente wie Potentiometer,eigene Gehäuse vorzusehen, in denen diese untergebracht werden.

Eine gewisse Problematik ergibt sich bei der Gehäusebildung oder Anordnung von elektrischen Schaltungen innerhalb von Gehäusen durch die Notwendigkeit, daß mindestens Teile dieser Schaltung gekühlt werden müssen, jedenfalls dann, wenn in der Schaltung nennenswerte Ströme fließen, diese also beispielsweise zum Regeln oder Steuern von motorischen Antrieben od. dgl. eingesetzt wird. In diesem Fall ist mindestens der Leistungshalbleiter zu kühlen, wegen der sonst nicht zu bewältigenden Verlustwärme.

Nicht selten geht man in diesem Zusammenhang so vor, daß man das Leistungshalbleiterschaltelement, meistens ein MOS-FET,aus der elektrischen Schaltung auch räumlich herausnimmt und mit großflächigen Kühlkörpern versieht oder diesen selbst in einer solchen Form ausbildet, woraufhin dann der Leistungshalbleiter an gesonderter Stelle mit anderen wärmeleitenden Materialien in Kontakt gebracht wird. Beispielsweise ist es bei einer elektrischen Steuerschaltung für die Regelung von Drehantrieben bei Elektrowerkzeugen od. dgl. bekannt, den Leistungshalbleiter, und nur diesen aus der kompakten Bauform des in einem Gehäuse angeordneten Elektronikschalters für den Steuer- und Regelvorgang herauszunehmen und an gesonderter Stelle innerhalb des den gesteuerten Motor aufnehmenden Gerätegehäuses in gut wärmeleitender Beziehung anzuordnen, üblicherweise anzuschrauben.

Dies ist umständlich, führt zu erhöhten Kosten und macht mindestens weitere Verdrahtungsschritte notwendig, die ebenfalls wieder Störungen unterworfen sein können.

Der Erfindung liegt daher die Aufgabe zugrunde, hier Abhilfe zu schaffen und ein Gehäuse für elektrische Schaltungen zur Verfügung zu stellen, welches in kompakter Form elektrische Schaltungen sicher und geschützt aufzunehmen imstande ist und gleichzeitig in der Lage ist, für die Abfuhr überschüssiger Wärmemengen, also für eine Kühlung zu sorgen.

## Vorteile der Erfindung

Die Erfindung löst diese Aufgabe mit den kennzeichnenden Merkmalen des Anspruchs 1 und hat den Vorteil, daß die erfindungsgemäße Gehäuseausbildung gleichzeitig zwei verschiedene Problemkreise anspricht und auch löst, die bisher getrennt betrachtet und strukturiert worden sind, nämlich einmal die Anordnung von elektrischen Schaltungen innerhalb von Gehäusen allgemein und deren Schutz, beispielsweise auch durch Vergießen, sowie andererseits die erforderliche Kühlung jedenfalls von bestimmten Schaltungselementen der elektrischen Schaltung - ein häufig auftretendes Problem, welches unbedingt gelöst werden muß, da es sonst zur Zerstörung jedenfalls dieser Schaltungselemente kommen kann.

Die Erfindung eignet sich mit besonderem Vorteil für kleinere kompakte schaltungen, die als selbständige Einheiten auf Schaltungs- oder Printplatten aufgebaut sind und zur Steuerung oder Regelung beispielsweise von elektrischen Antrieben, Motoren, Relais oder sonstigen anderen Baukomponenten dienen. Bei solchen Schaltungen ist es sehr erwünscht, diese nicht frei innerhalb des anderweitigen Gehäuses für den elektrischen Antrieb oder Motor anzuordnen, sondern in einem eigenen Gehäuse einerseits zu schützen, andererseits aber auch sicherzustellen, daß gerade bei solchen Anwendungsfällen die sich hierbei entwickelnde Verlustwärme auch effektiv und wirksam abgeführt wird, bevor die beteiligten Steuer- oder Regelbausteine der elektrischen Schaltung geschädigt werden.

Dabei ist ferner vorteilhaft, daß das die elektrische Schaltung aufnehmende Gehäuse diese von mindestens zwei Seiten, vorzugsweise von mehreren Seiten umschließt und das Gehäuse dann gleichzeitig den Vergußrahmen für die Schaltung bildet, also Gehäuse und Vergußrahmen in einem ist mit dem weiter vorn schon erwähnten zusätzlichen Vorteil, daß es das solchermaßen aufgebaute Gehäuse selbst ist, welches die wirksame Kühlung der in seinem Inneren angeordneten elektrischen Schaltungskomponenten realisiert.

Das Gehäuse nach vorliegender Erfindung kann dabei in vollständig beliebiger Form konzipiert sein; es verfügt jedenfalls über eine offene Seite, die von einem mit dem Gehäuse verbundenen Kühlkörper in Form der fehlenden Gehäusewand gebildet ist. Hierdurch gelingt es dem Gehäuse, die weiter vorn genannten Teilaufgaben gleichzeitig zu lösen, nämlich als Gehäuseschutz für die elektrische Schaltung zu bieten, einen Vergußrahmen für die elektrische Schaltung zu bilden und gleichzeitig deren Kühlung sicherzustellen.

Durch die in den Unteransprüchen aufgeführten Maßnahmen sind vorteilhafte Weiterbildungen und Verbesserungen des im Anspruch 1 angegebenen Gehäuses möglich. Besonders vorteilhaft ist die Ausbildung des Gehäuses in rechteckförmiger Schachtelform, wobei eine Längswandung von einem metallischen Kühlblech, beispielsweise einem Kupferblech gebildet ist, welches nach Art einer Kulissenführung durch Einschieben mit den restlichen Gehäusewandungen verbunden werden kann. Hierdurch entsteht dann auch eine beispielsweise lediglich auf einer Seite offene Schachtel, in die dann das Vergußmittel problemlos bis zu einem vorgegebenen Pegel eingefüllt werden kann. Innerhalb dieser "Gehäuseschachtel" befindet sich dann auch die elektrische Schaltung, die durch das Einfüllen des Vergußmittels vergossen wird und deren zur Entwicklung von Verlustwärme neigende Schaltungskomponenten in einer wärmeleitenden Beziehung zur Kühlkörper-Gehäusewandung stehen, vorzugsweise in enger Anlage an diese angeordnet sind.

Hierzu ist es möglich, von außen durch den Kühlkörper noch Verschraubungen anzubringen, die in entsprechende Kühlflächen von Schaltungskomponenten eingreifen und diese beim Anziehen in eine feste Anlage an die innere Fläche der Kühlkörper-Gehäusewandung bringen, so daß ein inniger Wärmeübergang möglich ist. Ergänzend kann man dann noch ein Vergußmaterial auswählen, welches möglichst ebenfalls gut wärmeleitend ist, so daß auch andere Baukomponenten von der guten Wärmeableitung durch die metallische oder kupferne äußere Gehäusewandung profitieren können und eine Verschlechterung der Wärmeübertragungseigenschaften bei direkter Anlage von Schaltungskomponenten an der Gehäusewandung auch dann nicht auftritt, wenn sich gegebenenfalls ein sehr dünner Vergußmittelfilm noch dazwischen legt.

Es versteht sich, daß das Gehäuse in anderen Ausführungsformen aber auch rund, viereckig oder von beliebiger Außenkontur sein kann.

Bevorzugt bildet das Gehäuse aber stets nach aufgebrachtem Kühlkörperwandungsbereich eine Art Hohlraum aus, in welchen- vor oder nach dem Verschluß des Gehäuses durch den Kühlkörper - die elektrische Schaltung eingebracht werden kann.

Bei einem bevorzugten Ausführungsbeispiel ist die elektrische Schaltung selbst wiederum auf einer kleineren Print- oder Schaltungsplatte angeordnet, die in das rechteckförmige Gehäuse - jedenfalls bei dieser Ausführungsform - in eigenen Führungsschienen eingeschoben werden kann und dort dann sicher gehalten ist, wobei hierdurch gleichzeitig auch die Abstandsbeziehungen der jeweiligen, besser zu kühlenden Schaltungskomponenten zur äußeren Gehäusewandung als Kühlkörper hergestellt wird.

Ein solches, die innere Schaltungsplatte sowie ein Vergußmittel tragendes Gehäuse weist dann eine bevorzugte einheitliche einstückige Kompaktform auf und kann problemlos an gegebener Stelle innerhalb größerer Geräte oder deren Gehäuseabmessungen angeordnet, beispielsweise verschraubt werden, wobei es hier ergänzend noch möglich ist, die eine Kühlkörper-Gehäusewandung weiter in wärmeleitenden Kontakt mit einem angrenzenden Gerätegehäuse zu bringen.

Es ist auch möglich, beim Vergießen eine vordere Randkante der in das Gehäuse eingeschobenen Schaltungsplatte freizulassen, an welcher sich Kontaktflächen befinden, so daß sofort auch die elektrischen Verbindungen in der üblichen Weise hergestellt werden können; alternativ kann durch das vollständige Einschieben einer Schaltungsplatte in das Gehäuse an beliebiger Stelle eine Kontaktgabe zwischen inneren Gehäuse-Kontaktanschlüssen, auch federnder Art, vorgenommen werden, während in anderen Gehäusebereichen nach außen reichende Kontaktzungen oder Stecker, gegebenenfalls auch Buchsenleisten u. dgl. angeformt, gleich eingegossen oder angesetzt sein können, zu denen dann die elektrischen Leitungsverbindungen durchkontaktiert sind.

Zeichnung

Ein Ausführungsbeispiel der Erfindung ist in der Zeichnung dargestellt und wird in der nachfolgenden Beschreibung näher erläutert. Es zeigen:

Fig. 1 ein durch eine äußere Kühlkörper-Wandung abgeschlossenes Gehäuse mit eine elektrische Schaltung tragender, eingeschobener Schaltungsplatte in perspektivischer Darstellung, ohne eingebrachtes Vergußmittel;

Fig. 2 das gleiche Gehäuse der Fig. 1 mit eingeschobener Schaltungsplatte, jedoch ohne ergänzende Kühlkörper-Wandung und

Fig. 3 den gleichzeitig einen Gehäusewandbereich bildenden Kühlkörper, ebenfalls in perspektivischer Darstellung und vorbereitet zum Einschieben längs seitlicher Gehäusenuten.

Beschreibung der Ausführungsbeispiele

Der Grundgedanke vorliegender Erfindung besteht darin, eine mindestens teilweise hohlkörperartige Gehäusestruktur so auszubilden, daß in deren Inneren eine elektrische Schaltung angeordnet werden kann und mindestens ein äußerer Wandbereich oder eine Seite dieser Gehäusestruktur unmittelbar von einem Kühlkörper gebildet ist, der insofern, nämlich nach dem Verbinden mit dem Gehäuse ein Kühlkörper-Wandungsbereich wird, so daß sich eine kompakte Gehäuseform mit innen liegender elektrischer Schaltung ergibt, die problemlos vergossen werden kann und dennoch in der Lage ist, mindestens bestimmte Schaltungskomponenten der elektrischen Schaltung wirksam zu kühlen.

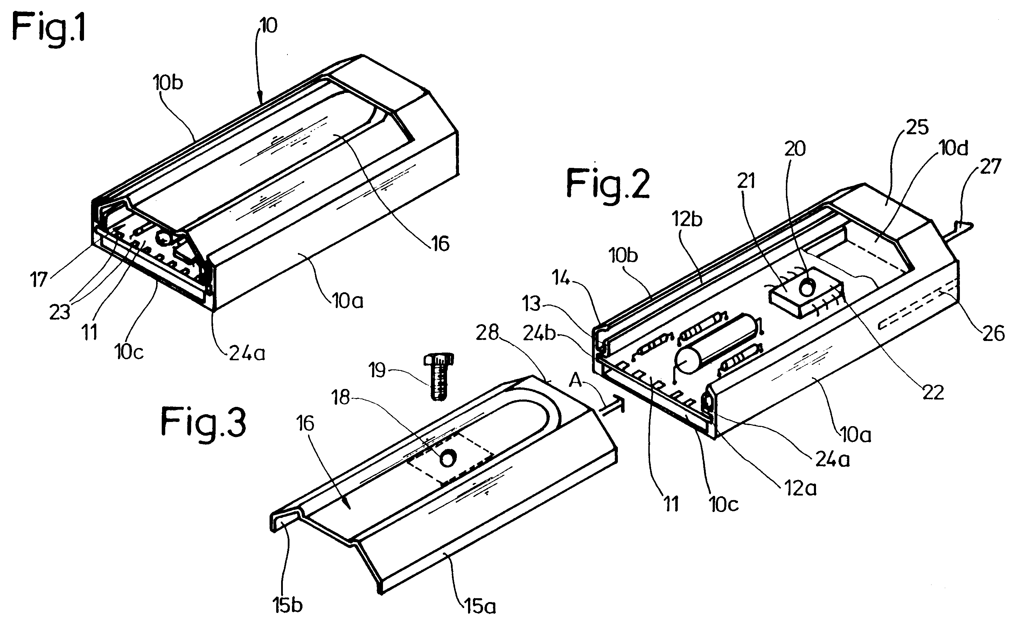

In Fig. 1 ist ein rechteckförmiges Gehäuse von allgemeiner Schachtelform gezeigt und mit 10 bezeichnet; das Gehäuse verfügt über zwei Seitenwände 10a, 10b, eine nur teilweise sichtbare Bodenwand 10c sowie gegebenenfalls auch eine rückseitige Querwand 10d, kann aber nach dieser Seite, im übrigen aber auch nach der Bodenseite offen sein, was schon deshalb möglich ist, weil dann eine in das Gehäuse eingesetzte und die elektrische Schaltung tragende Schaltungsplatte 11 die untere Gehäuseabschlußwandung 10c bilden könnte.

Wesentlich ist, daß mit einer solchen Gehäusestruktur, die innerhalb des erfinderischen Rahmens liegend natürlich auch eine vollständig andere Form, beispielsweise kreisrund, viereckig, oval, elliptisch, eiförmig od. dgl. aufweisen kann, ein Wandungsbereich verbunden werden kann, der gleichzeitig einen Kühlkörper bildet. Dies bedeutet mit anderen Worten, daß das Gehäuse ohne Kühlkörper insoweit unvollständig oder mindestens auf einer Seite zusätzlich offen ist, die in der Darstellung der Fig. 2 einer oberen Deckwand entsprechen würde.

Man erkennt aus der Darstellung der Fig. 2, daß die seitlichen Gehäusewände 10a, 10b sich nach oben unter Bildung einer Führungsnut 12a, 12b doppelwandig öffnen, so daß zwei im Abstand zueinander verlaufende Teilwände 13 und 14 gebildet sind. Die sich hierdurch ergebende Führungsnut 12a, 12b ist so ausgebildet, daß Seitenkanten 15a, 15b des weiteren Gehäusewandbereichs 16, der gleichzeitig ein Kühlkörper ist, längs der Führungsnuten eingeschoben werden können, dabei dem Pfeil A folgend, so daß sich schließlich die durch die Kühlkörper-Wandung 16 abgedeckte obere Gehäusefläche entsprechend Fig. 1 ergibt. Dabei sind die Teilwandungen 13, 14, die die Führungsnuten 12a, 12b bilden, so elastisch verformbar und einander angenähert, daß die entsprechenden Kühlkörper-Randkanten 15a, 15b unter Preßdruck aufgenommen werden, was der Erzielung einer gewünschten Dichtigkeit entspricht und sicherstellt, daß beim Einfüllen von Verußmasse in den so gebildeten Hohlraum 17 (Fig. 1) des Gehäuses die Verußmasse nicht aus dem Übergangsbereich zwischen Kühlkörper-Wandung 16 und den angrenzenden Gehäusewandungen herausguillt.

Es versteht sich natürlich, daß die Verbindung zwischen der Kühlkörper-Wandung einerseits und den angrenzenden Gehäusestrukturen andererseits auch auf völlig andere Weise hergestellt werden kann als durch das beschriebene Einschieben von Randkanten längs Führungsnuten - so könnte beispielsweise ein kreisförmiger Gehäuseabschlußdeckel auch einfach in eine entsprechende offene Ringform eines Gehäuses eingeschnappt werden. Auch ist es möglich, das Gehäuse hierdurch völlig zu schließen und die Verußmasse durch eine kleine Bohrung unter Druck einzuführen mit der Möglichkeit der Entlüftung durch kleine Zweitbohrungen, wie es andererseits aber auch möglich ist, ein solches Gehäuse überhaupt nur aus Schaltungsplatte 11 und Kühlkörper-Wandung sowie diese beiden miteinander verbindenden und im Abstand haltenden Seitenwandbereichen 10a, 10b herzustellen, wenn man nämlich den Verguß so vornimmt, daß man offene Flächen durch Aufsetzen des so gebildeten Gehäuses abdeckt und eine der Seiten ohnehin zum Einfüllen der Verußmasse offen bleiben sollte.

Man erkennt, daß durch diese Maßnahmen schon eine wirksame Kühlung der innerhalb des Gehäuses in der Verußmasse befindlichen elektrischen Schaltungskomponenten erreicht wird in Richtung auf die gut leitende metallische Kühlkörper-Gehäusewandung 16, die bevorzugt ein entsprechend geformtes, dickeres Kupferblech sein kann.

In einer Ausgestaltung vorliegender Erfindung ist es ferner selbstverständlich möglich, die Abstandsbeziehung zwischen der inneren Fläche der Kühlkörper-Gehäusewandung und einem oder mehreren, höhere Verlustwärme aufweisenden Schaltungselementen bzw. deren eigenen kleineren Kühlflächen so gering zu halten, daß diese Schaltungselemente oder deren Kühlflächen unmittelbar beim Zusammenbau an den Kühlkörper-Wandbereich 16 innen zur Anlage kommen, mit einer dann entsprechend großen Wärmeableitfläche, gebildet von dem Kühlkörper.

Um hier ganz sicherzugehen, kann man ferner in der Kühlkörper-Wandung 16 an einer geeigneten Stelle Bohrungen 18 vorsehen, in welche beispielsweise Schraubbolzen 19 oder sonstige Befestigungsmittel eingeführt werden können, die dann in Gewindeöffnungen 20 von Kühlkörpern von hohen Verlustleistungen aufweisenden Schaltungselementen oder in diese direkt, soweit möglich,eingeschraubt werden, wodurch die größerer Oberfläche 21 solcher Schaltungselemente 22 (Fig. 2), vollständig flächig anliegend innen an die Kühlkörper-Wandung 16 herangezogen und herangepreßt wird. Damit wird dann die äußere Kühlkörper-Wandung 16 des Gehäuses 10 gleichzeitig die Kühlfahne für das innere Schaltungselement 22, welches, beispielsweise bei Drehantrieben etwa ein Triac oder ein sonstiges Element mit hoher Verlustleistung sein kann.

Die elektrische Kontaktgabe zwischen der elektrischen Schaltung und dem Gehäuse kann in einfacher Weise so erfolgen, daß nach außen oder zum offenen Bereich des Gehäuses weisende Kontaktflächen 23 an der die elektrischen Schaltungskomponenten tragenden Schaltungsplatte 11 angeordnet sind, so daß hier leicht weiterführende Kontaktierungen vorgenommen werden können; es ist aber auch möglich, bei vollständigem Einschub auf der gegenüberliegenden Seite (aber auch auf den Randseiten) Gegenkontakte innerhalb des Gehäuses zu berühren, die dann weiterführend mit in dem Gehäuse beispielsweise eingegossenen oder sonstwie an diesem befestigten Kontaktzungen, Kontaktstecker, Kontaktbuchsen u. dgl. in Kontakt stehen.

Man erkennt, daß durch die feste Verbindung der Kühlkörper-Wandung 16 mit den restlichen Gehäuseteilen ein widerstandsfähiges, auch gegen rauhe äußere Behandlung resistentes Gehäuse gebildet ist, dessen Widerstandsfähigkeit, auch gegen Schlageinwirkung u. dgl. durch das Einfüllen einer Vergußmasse in das Gehäuseinnere noch verstärkt wird.

Zur sicheren Verankerung und Führung der die elektrischen Schaltungskomponenten innerhalb des Gehäuses tragenden Leitungsplatte 11 können, beispielsweise wenn das Gehäuse die schachtelförmige Struktur wie in den Figuren 1 und 2 gezeigt hat, seitliche innere Führungsleisten oder Ausnehmungen 24a, 24b vorgesehen sein, gebildet von den seitlichen Gehäusewänden 10a, 10b, in die die Schaltungsplatte sozusagen schubladenartig eingeführt wird bis zum Anschlag, in welchem dann auch bei innerer Kontaktgabe an der Schaltungsplatte 11 vorgesehene Kontaktflächen mit gehäuseinneren Kontaktsteckern in Wirkverbindung treten.

Ferner kann das schachtelförmige Gehäuse eine im wesentlichen weitgehend geschlossene Form aufweisen mit Ausnahme einer vorderen Stirnwand, durch welche das Vergußmittel eingefüllt wird und einem Teilbereich der Abdeckwandung, so daß auch ein oberer restlicher Teilwandbereich 25 stehen bleibt, der auch der besseren Einführung und Aufnahme der Kühlkörper-Wandung 16 dienen kann. Es ist auch möglich, daß sich die beidseitigen Führungsnuten 12a, 12b in der hinteren Abschluß-Querwandung 10d fortsetzen, so daß ein vollständiges dichtes Einsetzen der Kühlkörper-Wandung 16 in die Gehäusestruktur möglich ist, wobei auch die vordere Stirnkante 28 der Kühlkörper-Wandung 16 in einer Dichtnut aufgenommen ist. Die Führungen für die Kühlkörper-Wandung innerhalb des Gehäuses können auch so beschaffen sein, daß die Kühlkörper-Wandung 16 nur in einer vorgegebenen Richtung und in vorgegebener Orientierung eingeschoben werden kann, was die Montage auch bei weniger fachgerechtem Personal ermöglicht.

Schließlich ist es noch möglich, außen am Gehäuse weitere Führungsnuten oder Führungsleisten 26 sowie Verrastungsmittel 27 vorzusehen, mit welchen dann das Kompaktgehäuse selbst innerhalb der Gehäusewandung eines größeren Geräts angeordnet und verankert werden kann, bei gleichzeitiger weiterführender elektrischer Kontaktgabe.

Abschließend wird darauf hingewiesen, daß die Ansprüche und insbesondere der Hauptanspruch Formulierungsversuche der Erfindung ohne umfassende Kenntnis des Stands der Technik und daher ohne einschränkende Präjudiz sind. Daher bleibt es vorbehalten, alle in der Beschreibung, den Ansprüchen und der Zeichnung dargestellten Merkmale sowohl einzeln für sich als auch in beliebiger Kombination miteinander als erfindungswesentlich anzusehen und in den Ansprüchen niederzulegen sowie den Hauptanspruch in seinem Merkmalsgehalt zu reduzieren.

**Patentansprüche**

1. Gehäuse für elektrische Schaltungen, insbesondere Vergußgehäuse für elektrische (Dreh)-Regel- und Steuer-Antriebe von Elektro(hand)werkzeugen u. dgl., gekennzeichnet durch eine mindestens an einer Stelle offene, für die Aufnahme elektrischer Schaltungen oder Leitungsplatten (11) geeignete Gehäusestruktur (10) sowie einen die offene Gehäusestelle nach außen abdeckenden Kühlkörper-Wandbereich (16) aus gut wärmeleitendem Material, der mit mindestens einem elektrischen Schaltungselement der elektrischen Schaltung in wärmeleitender Verbindung steht.

2. Gehäuse nach Anspruch 1, dadurch gekennzeichnet, daß die wärmeleitende Verbindung des mindestens einen elektrischen Schaltungselements (22) über ein inneres Vergußmaterial erfolgt.

3. Gehäuse nach Anspruch 1, dadurch gekennzeichnet, daß die gute wärmeleitende Verbindung des mindestens einen elektrischen Schaltungselements (22) durch unmittelbare Anlage des elektrischen Schaltungselements oder einer von diesem ausgehenden eigenen Kühlkörperfahne an der Innenseite der Kühlkörper-Wandung (16) hergestellt ist.

4. Gehäuse nach einem der Ansprüche 1-3, dadurch gekennzeichnet, daß die Gehäusestruktur so ausgelegt ist, daß in Verbindung mit der mit dieser verbundenen Kühlkörper-Wandung (16) ein nach einer oder mehreren Seiten offener Hohlraum (17) gebildet ist zur Aufnahme von diesen Hohlraum ganz oder teilweise ausfüllender Vergußmasse.

5. Gehäuse nach einem der Ansprüche 1-4, dadurch gekennzeichnet, daß zusätzlich zu der Kühlkörper-Gehäusewandung (16) eine weitere Gehäusewandung von der Unterseite einer in das Gehäuse eingesetzten Schaltungsplatte (11) gebildet ist, wobei mindestens Seitenwandbereiche (10a, 10b) vorgesehen sind, die Schaltungsplatte (11) mit den elektrischen Schaltungskomponenten sowie die Kühlkörper-Wandung (16) in vorgegebener Beziehung zueinander lagern.

6. Gehäuse nach einem oder mehreren der Ansprüche 1-5, dadurch gekennzeichnet, daß das Gehäuse eine allgemein rechteckförmig/längliche Schachtelform aufweist mit einer offenen Stirnfläche und seitlichen Wandteilen (10a, 10b), die beidseitig Führungsnuten (12a, 12b) bilden zur Aufnahme von in sie einzuschiebenden Randkanten (15a, 15b) einer ebenfalls in etwa rechteckförmigen Blechform der Kühlkörper-Wandung (16).

7. Gehäusenach einem der Ansprüche 1-6, dadurch gekennzeichnet, daß in der Kühlkörper-Wandung (16) Durchbrechungen (18) vorgesehen sind zur Aufnahme von mit Kühlfahnen von elektrischen Schaltungselementen und mit diesen direkt zu verbindenden Schraubmitteln (19) derart, daß diese beim Anschrauben flächig abstandsfrei gegen die Innenfläche der metallischen Kühlkörper-Wandung (16) gepreßt sind.

8. Gehäuse nach einem der Ansprüche 1-7, dadurch gekennzeichnet, daß die Kühlkörper-Wandung (16) ein massives Kupferblech ist.

9. Gehäuse nach einem der Ansprüche 1-8, dadurch gekennzeichnet, daß Schnapp- oder Rastmittel im Übergangsbereich zwischen der Kühlkörper-Wandung (19) und den angrenzenden Gehäusestrukturbereichen vorgesehen sind zur dichten und sicheren Verbindung.

10. Gehäuse nach einem der Ansprüche 1-9, dadurch gekennzeichnet, daß unterhalb den Führungsnuten (12a, 12b) für die Kühlkörper-Wandungsrandbereiche (15a, 15b) separate Führungsleisten (24a, 24b) im Gehäuse vorgesehen sind zur Ermöglichung des Einschubs von mit elektrischen Bauelementen bestückten Leiterplatten in vorgegebenem Abstand zur Kühlkörper-Wandung (16).

11. Gehäuse nach einem oder mehreren der Ansprüche 1-10, dadurch gekennzeichnet, daß an der Schaltungsplatte (11) nach außen zur Kontaktierung gerichtete flächige Kontakte (23) angeordnet sind.

12. Gehäuse nach einem der Ansprüche 1-11, dadurch gekennzeichnet, daß die Schaltungsplatten-Kontakte (23) beim vollständigen Einschieben mit gehäuseinineren Gegenkontakten (Federn) in elektrische Kontaktverbindung treten, wobei die Gegenkontakte ihrerseits über innere Verbindungsleitungen des Gehäuses zu einer äußeren Kontaktleiste, Buchsenleiste, Steckerleiste od. dgl. geführt sind.

13. Gehäuse nach einem der Ansprüche 1-12, dadurch gekennzeichnet, daß die Gehäusestruktur schuhförmig ausgebildet ist mit lediglich einer offenen Stirnfläche und einer lediglich teilweise offenen oberen Abschlußwandung (25), die durch die eingeschobene Kühlkörper-Wandung (16) vervollständigt wird.

14. Gehäuse nach einem oder mehreren der Ansprüche 1-13, dadurch gekennzeichnet, daß die äußere Gehäuseform ihrerseits Führungsleiste bzw. Führungsnuten (26) und äußere Rastmittel (27) aufweist zur eigenen Verankerung in einem Gerätegehäuse.

Fig.1

Fig.2

Fig.3

Europäisches
Patentamt

# EUROPÄISCHER RECHERCHENBERICHT

Nummer der Anmeldung

EP 91 12 0213

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 237 878 (ANT NACHRICHTENTECHNIK) <br> * das ganze Dokument * <br> --- | 1 | H05K7/20 |
| A | EP-A-0 130 279 (MITSUBISHI DENKI KABUSSHIKI KAISHA) <br> * das ganze Dokument * <br> --- | 1 | |
| A | DE-U-8 528 177 (EBERLE GMBH) <br> * das ganze Dokument * <br> --- | 1 | |
| A | DE-A-3 627 372 (LOEWE OPTA GMBH) <br> * das ganze Dokument * <br> ----- | 1 | |
| | | | **RECHERCHIERTE SACHGEBIETE (Int. Cl.5)** <br><br> H05K |

Der vorliegende Recherchenbericht wurde für alle Patentansprüche erstellt

| Recherchenort | Abschlußdatum der Recherche | Prüfer |
|---|---|---|
| DEN HAAG | 06 MAERZ 1992 | TOUSSAINT F.M.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes
    Dokument